# EUROPEAN PATENT APPLICATION

(11) **EP 1 480 080 A1**
(43) Date of publication of application: **24.11.2004**
(21) Application number: 03253213.7
(22) Date of filing: 22.05.2003
(51) Int. Cl.: G03F 7/20

(54) **Lithographic apparatus and device manufacturing method**

(71) Applicant: ASML Netherlands B.V., 5504 DR Veldhoven (NL)
(72) Inventor: The designation of the inventor has not yet been filed
(74) Representative: Leeming, John Gerard

(57) **Abstract**

A lithographic projection apparatus comprises a microlens array (11) for generating a plurality of source images in a two-dimensional array, a programmable patterning means (12) having a plurality of addressable elements acting as shutters for the source images and a projection subsystem (13) for projecting an image of the array of source images onto a substrate. A greater working distance can thereby be obtained.

## Description

The present invention relates to a lithographic projection apparatus comprising:
- an illumination system for supplying a projection beam of radiation;
- programmable patterning means comprising a plurality of addressable elements and capable of being set in accordance with a desired pattern;
- a substrate table for holding a substrate; and
- a projection system for transferring the desired pattern onto a target portion of the substrate.

Lithographic projection apparatus can be used, for example, in the manufacture of integrated circuits (ICs). In such a case, the programmable patterning means may generate a circuit pattern corresponding to an individual layer of the IC, and this pattern can be imaged onto a target portion (*e.g*. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus ― commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

A microscopy and/or lithography system employing a microlens array is described in US 6,133,986. The basic layout of such a lithography apparatus is shown in Figure 1 of the accompanying drawings. Light from a light source LA is collimated and directed, via a beam splitter BS onto a spatial light modulator SLM, constituted by a digital micro-mirror array. The individual mirrors of the array can be set to either direct light out of the system or back through the beamsplitter BS to a projection lens system PL which projects an image of the spatial light modulator onto a microlens array MLA, which has microlenses in 1:1 relationship with the individual mirrors of the spatial light modulator. Each lens of the microlens array images the projection aperture onto a respective spot on the substrate W. Thus an array of spots on the substrate can be selectively exposed according to the setting of the corresponding mirror in the spatial light modulator and by scanning the substrate, the whole surface thereof can be selectively exposed.

The above system has a number of advantages but one drawback of it is the small working distance, which is determined by the focal length of the microlenses and may be less than 1mm, between the microlens array and the substrate. This causes problems such as increased potential for contamination of the microlens array and increased potential for collisions between substrate and the microlens array. Also, little space is available for sensors such as height and tilt sensors required for levelling control during scanning exposures.

It is an object of the present invention to provide a lithographic projection apparatus employing a programmable patterning means and a microlens array but having a larger working distance.

This and other objects are achieved according to the invention in a lithographic apparatus as specified in the opening paragraph, characterized in that said projection system comprises:
a microlens array having a plurality of microlenses corresponding to said addressable elements of said programmable patterning means and for forming an array of source images; and
a projection subsystem for projecting an image of said array of source images onto said substrate.

With this arrangement, the working distance is no longer limited by the focal length of the microlens array but rather can be set with much greater freedom by appropriate design of the projection subsystem. The projection subsystem may be a (refractive) lens system of known type and may project a 1:1 or reduced image of the source image array.

In a preferred embodiment of the invention, the illumination system delivers a substantially collimated beam of radiation to the microlens array which forms the array of source images therefrom. The programmable patterning means is a selectively transmissive device (e.g. an LCD array) positioned proximate to the microlens array whereby addressable elements of the programmable patterning means may be set to block respective ones of the source images. This provides a simple, robust system. To minimize absorption by inactive parts of the programmable patterning means, it is preferably placed close to the plane of said source images so that each of the beams fits within the transmissive part of each addressable element of the programmable patterning means.

In another preferred embodiment of the invention, the projection system further comprises a second projection subsystem for projecting an image of said programmable patterning means onto said microlens array.

The second projection subsystem may be a (refractive) lens system of known type and provides additional flexibility of design of the apparatus. For example, by designing the second projection subsystem with appropriate magnification or reduction, it becomes possible to use a programmable patterning means and a microlens arrays of different scales.

Advantageously, the microlens array can be arranged to project said source images onto a spherical surface. This allows the size of the elements making up the projection subsystem to be reduced.

According to a further aspect of the invention there is provided:
a device manufacturing method comprising the steps of:
   - providing a substrate that is at least partially covered by a layer of radiation sensitive material;
   - providing a projection beam of radiation using an illumination system;
   - setting a plurality of addressable elements of a programmable patterning means in accordance with a desired pattern;
   - transferring the desired pattern onto a target portion of the layer of radiation-sensitive material using a projection system,
characterized in that said projection system comprises:
a microlens array having a plurality of microlenses corresponding to said addressable elements of said programmable patterning means and for forming an array of source images; and
a projection subsystem for projecting an image of said array of source images onto said substrate.

The term "programmable patterning means" as here employed should be broadly interpreted as referring to means that can be used to endow an incoming radiation beam with a patterned cross-section, corresponding to a pattern that is to be created in a target portion of the substrate; the terms "light valve" and "Spatial Light Modulator" (SLM) can also be used in this context. Generally, the said pattern will correspond to a particular functional layer in a device being created in the target portion, such as an integrated circuit or other device (see below). Examples of such patterning means include:
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An array of grating light valves (GLV) can also be used in a corresponding manner. Each GLV is comprised of a plurality of reflective ribbons that can be deformed relative to one another to form a grating that reflects incident light as diffracted light. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the programmable patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference.
- A programmable LCD array. An example of such a construction is given in United States Patent US 5,229,872, which is incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g*. with a wavelength of 365, 248, 193, 157 or 126 nm) and EUV (extreme ultra-violet radiation, *e.g.* having a wavelength in the range 5-20 nm), as well as particle beams, such as ion beams or electron beams.

Embodiments of the invention will now be described, by way of example only, with reference to the accompanying schematic drawings in which:
Figure 1 depicts the optical system of a prior art lithographic projection apparatus;
Figure 2 depicts a lithographic projection apparatus according to a first embodiment of the invention; and
Figure 3 depicts a lithographic projection apparatus according to a first embodiment of the invention.

In the Figures, corresponding reference symbols indicate corresponding parts.

### Embodiment 1

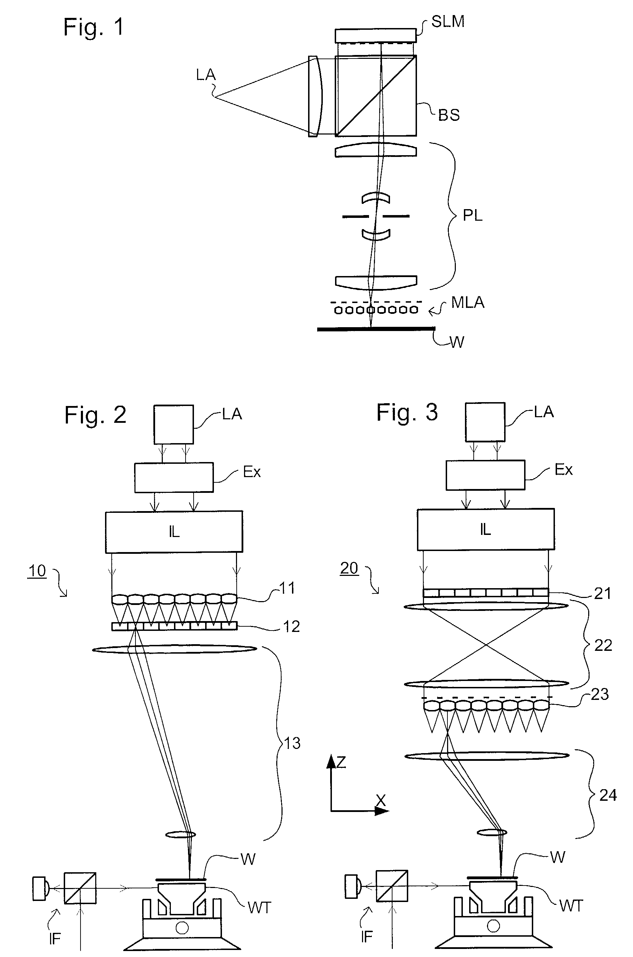

Figure 2 schematically depicts a lithographic projection apparatus 10 according to a particular embodiment of the invention. The apparatus comprises:
· a radiation system LA, Ex, IL, for supplying a projection beam of radiation (*e.g*. UV radiation);
· an array of microlenses 11 for forming a plurality of source images in a two-dimensional array;
· a programmable patterning means 12 (*e.g.* an SLM) having a plurality of addressable elements corresponding to the plurality of source images formed by the array of microlenses;
· a substrate table WT provided with a substrate holder for holding a substrate W (*e.g.* a resist-coated glass plate on which a flat panel display is to be constructed), and connected to positioning means for accurately positioning the substrate;
· a projection subsystem ("lens") 13 (*e.g.* a quartz and/or CaF₂ lens system or a catadioptric system comprising lens elements made from such materials, or a mirror system) for imaging the plurality of source images onto a target portion C (*e.g.* comprising part of, one or several dies) of the substrate W.

The source LA (*e.g.* an Hg lamp) produces a beam of radiation. This beam is fed into an illumination system (illuminator) IL, either directly or after having traversed conditioning means, such as a beam expander Ex, for example. The illuminator IL may comprise adjusting means for setting the outer and/or inner radial extent (commonly referred to as σ-outer and σ-inner, respectively) of the intensity distribution in the beam. In addition, it will generally comprise various other components, such as an integrator and a condenser. In this way, the beam impinging on the microlens array has a desired uniformity, intensity distribution and distribution of angles.

The microlens array 11 forms a plurality of source images, one per microlens in the array, which are considerably smaller than the cross-sections of the microlenses. It may also be regarded as dividing the beam into a plurality of sub-beams and therefore may be replaced by another component performing that function. These source images are then projected onto the substrate W by the projection subsystem 13 so as to expose an array of small, spaced-apart spots on the substrate. The projection subsystem 13 preferably has a magnification M of 1 or less so that the array of spots on the substrate is the same size as or smaller than the array of source images.

The addressable elements of the programmable patterning means act as individually controllable shutters for the source images so that the spots on the substrate can be turned off and on as desired. To this end, the programmable patterning means 12 may be placed before or after the microlens array but is conveniently placed close to the plane of the source images, where the pencil of rays making up each sub-beam is narrow so as to avoid absorption of the beam by inactive parts, e.g. pixel borders, of the programmable patterning means.

With the aid of the positioning means (and interferometric measuring means IF), the substrate table WT is be moved accurately to scan the substrate W under the projection subsystem 13 in a scan direction, e.g. the y direction. Movement of the substrate table WT may be realized with the aid of a long-stroke module (course positioning) and a short-stroke module (fine positioning), which are not explicitly depicted in Figure 2.

The array of microlenses, and hence the array of source images and the array of spots projected onto the substrate, is at an acute angle to the scan direction. The angle of the array, its spacing, the number of rows and the spot size are selected so that as the substrate is scanned under the projection subsystem 13 its entire area is swept by the projected spots. In this way, the substrate may be selectively exposed at a resolution much higher than the spacing of the source images generated by the microlens array without requiring a projection subsystem with a very high reduction ratio.

The projection subsystem 13 can be arranged to have a relatively long focal length allowing as large a working distance between the final lens element and the substrate as desired. To enable the size of the elements of the projection subsystem to be reduced, the microlens array may be arranged to project the source images onto a spherical surface.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and claims encompass both of these scenarios.

As here depicted, the apparatus is of a transmissive type (*i.e.* has a transmissive programmable patterning means). However, in general, it may also be of a reflective type, for example (*i.e*. with a reflective programmable patterning means). Also, rather than simply being an on-off shutter, the programmable patterning means may enable the amount of light passing through each addressable element to be controlled among a plurality of levels, or even over a continuum, to allow grayscale exposures.

### Embodiment 2

A lithographic projection apparatus 20 according to a second embodiment of the invention is shown in Figure 3 and is the same as the first embodiment save as described below.

In the second embodiment, the projection system comprises an array of microlenses 23 and first and second projection subsystems 24, 22 and the programmable patterning means is before the projection system. The first projection subsystem 24 corresponds to the projection subsystem of the first embodiment and projects the source images generated by the microlens array onto the substrate W. The second projection subsystem projects an image of the programmable patterning means 21 onto the microlens array so that if an element of the programmable patterning means is shut, no light reaches the corresponding microlens array.

The second projection system 22 may be provided with a magnification or reduction ratio to match together a programmable patterning means and a microlens array having different pitches. It is even possible for the second projection system to have asymmetric magnification or reduction ratios if the aspect ratios of the programmable patterning means and the microlens arrays differ.

Whilst specific embodiments of the invention have been described above, it will be appreciated that the invention may be practiced otherwise than as described. The description is not intended to limit the invention.

## Claims

1. A lithographic projection apparatus comprising:
- an illumination system for supplying a projection beam of radiation;
- programmable patterning means comprising a plurality of addressable elements and capable of being set in accordance with a desired pattern;
- a substrate table for holding a substrate; and
- a projection system for transferring the desired pattern onto a target portion of the substrate; **characterized in that** said projection system comprises:
a microlens array having a plurality of microlenses corresponding to said addressable elements of said programmable patterning means and for forming an array of source images; and
a projection subsystem for projecting an image of said array of source images onto said substrate.

2. Apparatus according to claim 1 wherein said illumination system delivers a substantially collimated beam of radiation to the microlens array which forms the array of source images therefrom and said programmable patterning means is a selectively transmissive device positioned proximate to the microlens array whereby addressable elements of the programmable patterning means may be set to block respective ones of the source images.

3. Apparatus according to claim 2 wherein said programmable patterning means is preferably close to the plane of said source images.

4. Apparatus according to claim 1 wherein said projection system further comprises a second projection subsystem for projecting an image of said programmable patterning means onto said microlens array.

5. Apparatus according to claim 4 wherein said programmable patterning means and said microlens arrays have different pitches and/or aspect ratios and said second projection subsystem has appropriate magnification(s) or reduction(s) to match said addressable elements of said programmable patterning means to microlenses of said microlens array.

6. Apparatus according to any one of the preceding claims wherein said microlens array is arranged to project said source images onto a spherical surface.

7. Apparatus according to any one of the preceding claims wherein said proj ection subsystem projects a 1:1 or reduced image of the source image array.

8. A device manufacturing method comprising the steps of:
- providing a substrate that is at least partially covered by a layer of radiation sensitive material;
- providing a projection beam of radiation using an illumination system;
- setting a plurality of addressable elements of a programmable patterning means in accordance with a desired pattern;
- transferring the desired pattern onto a target portion of the layer of radiation-sensitive material using a projection system,
**characterized in that** said projection system comprises:
a microlens array having a plurality of microlenses corresponding to said addressable elements of said programmable patterning means and for forming an array of source images; and
a projection subsystem for projecting an image of said array of source images onto said substrate.
